# EUROPÄISCHE PATENTSCHRIFT

(11) **EP 0 607 789 B1**
(45) Veröffentlichungstag und Bekanntmachung des Hinweises auf die Patenterteilung: **28.07.1999**
(21) Anmeldenummer: 94100042.4
(22) Anmeldetag: 04.01.1994
(51) Int. Cl.: G06G 7/24, H03G 7/00

(54) **Schaltungsanordnung zur Erzeugung eines exponentiell von einem Eingangssignal abhängigen Ausgangssignals**
Circuit for generating an output signal exponentially depending on the input signal
Circuit pour générer un signal de sortie exponentielle dépendant d'un signal d'entrée

(30) Priorität: 13.01.1993 DE 4300591; 13.01.1993 DE 4300592
(43) Veröffentlichungstag der Anmeldung: 27.07.1994
(73) Patentinhaber: TEMIC Semiconductor GmbH, 74072 Heilbronn (DE)
(72) Erfinder: Burkhart, Johann, D-89284 Pfaffenhofen (DE); Hirsch, Konrad, D-85356 Freising (DE); Eberhardt, Kurt, D-89081 Ulm (DE); Traub, Johann, D-89415 Lauingen (DE)
(74) Vertreter: Maute, Hans-Jürgen, Dipl.-Ing.

(56) Entgegenhaltungen:
- EP-A- 0 331 234
- NEW ELECTRONICS, Bd.16, Nr.15, Juli 1983, LONDON GB Seite 18 CATTO 'Log and anti-log controls'
- PATENT ABSTRACTS OF JAPAN vol. 8, no. 221 (E-271) (1658) 9. Oktober 1984 & JP-A-59 104 811 (YOKOGAWA) 16. Juni 1984
- IBM TECHNICAL DISCLOSURE BULLETIN., Bd.6, Nr.3, August 1963, NEW YORK US Seiten 70 - 71 FUNK 'Amplifier with automatic gain control'

## Beschreibung

Die Erfindung betrifft eine Schaltungsanordnung nach dem Oberbegriff des Patentanspruchs 1.

Eine derartige Schaltungsanordnung ist beispielsweise als Exponentialfunktionsgenerator in dem Buch "Halbleiterschaltungstechnik" von Tietze und Schenk beschrieben und enthält als wesentliches Element neben dem Differenzverstärker einen Operationsverstärker. Gegenüber einer Anordnung mit nur einem Transistor in Emitterschaltung weist die Anordnung mit einem Differenzverstärker insbesondere den Vorteil auf, temperaturkompensiert zu sein.

Der vorliegenden Erfindung liegt die Aufgabe zugrunde, eine derartige Schaltungsanordnung anzugeben, die einfach aufgebaut ist.

Die Erfindung ist im Patentanspruch 1 beschrieben. Die weiteren Ansprüche enthalten vorteilhafte Ausführungen, Weiterbildungen und Verwendungen der Erfindung.

Die erfindungsgemäße Schaltungsanordnung liefert mit geringem Aufwand ein exponentiell von einem Eingangssignal abhängiges Ausgangssignal und ist insbesondere vorteilhaft zur Erzeugung eines Ausgangsstroms. Die Schaltungsanordnung kann für niedrige Betriebsspannungen bis zu 1 V ausgeführt werden.

Der Ausgangsstrom ist begrenzbar durch Vorgabe des Referenzstroms oder in einer Weiterbildung der Erfindung durch eine Regelschleife. Die Erfindung ist besonders vorteilhaft in einer Einrichtung zur Verstärkungsregelung (AGC) für amplitudenmodulierte Signale, insbesondere Signale mit Amplitudenumtastung wie beispielsweise die Funksignale von Zeitzeichensendern wie dem DCF 77.

Die Erfindung ist nachfolgend anhand von Beispielen unter Bezugnahme auf die Abbildungen noch eingehend veranschaulicht. Dabei zeigt
- FIG. 1: den prinzipiellen Aufbau einer erfindungsgemäßen Schaltungsanordnung
- FIG. 2: eine erste Anordnung zur Begrenzung eines Ausgangsstroms
- FIG. 3: eine weitere Anordnung zur Begrenzung eines Ausgangsstroms
- FIG. 4: eine bevorzugte Ausführung einer erfindungsgemäßen Schaltungsanordnung in Verbindung mit einer Anordnung zur Begrenzung des Ausgangsstroms für eine AGC-Verstärkereinrichtung
- FIG. 5: ein Kennliniendiagramm für die Ansteuerung eines AGC-Verstärkers

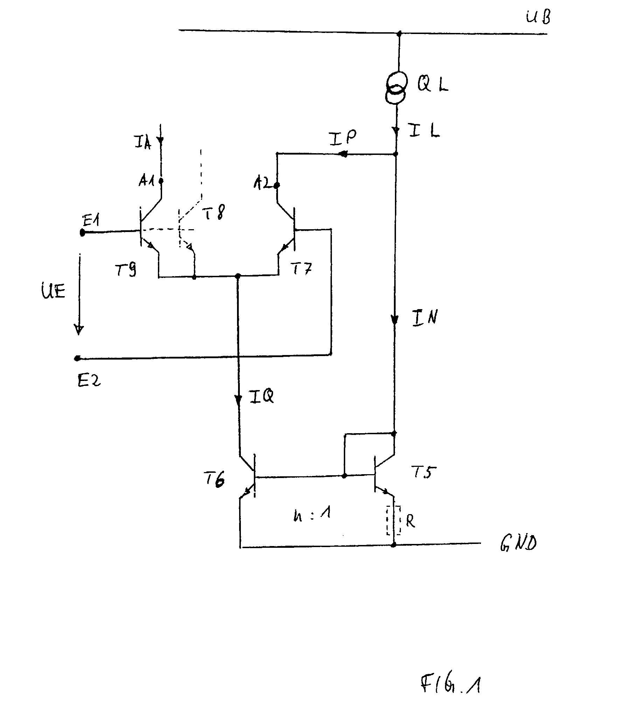

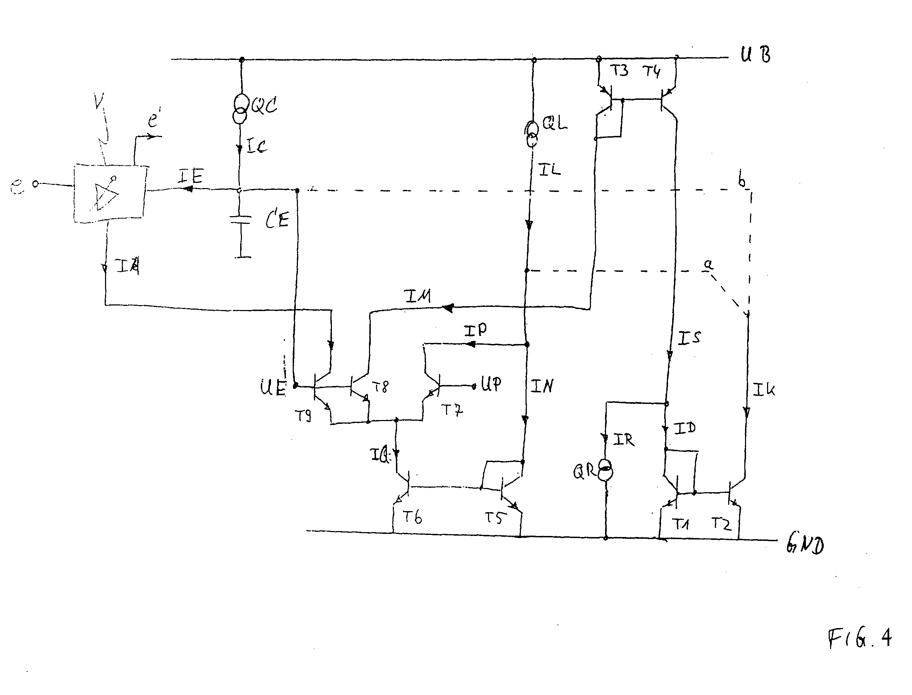

Bei der in Fig.1 skizzierten Anordnung bilden die Transistoren T7, T9 einen Differenzverstärker mit Eingängen E1, E2 und Ausgängen A1, A2. Ein Eingangssignal UE kann symmetrisch (wie in FIG. 1) oder unsymmetrisch an den Differenzverstärker angelegt sein, wobei bei unsymmetrischer Aussteuerung (FIG. 4) mit einem auf eine feste Vergleichsspannung gelegten Eingangsanschluß die Vergleichsspannung über Diodenstrecken eingestellt und dadurch die Temperaturabhängigkeit der Anordnung kompensiert werden kann. Durch Einfügen von Dioden in die Emitterleitung sowohl von T9 (und T8,..) als auch von T7 kann der Aussteuerbereich der Anordnung vergrößert werden. Der Transistor T6 bildet über den Stromspiegel mit dem Transistor T5 eine steuerbare Stromquelle für den Betriebsstrom IQ des Differenzverstärkers. Der Betriebsstrom IQ wird nach Maßgabe des Eingangssignals UE auf die Ausgänge A1, A2 des Differenzverstärkers aufgeteilt in einen Ausgangsstrom IA als weiterverwendetem Ausgangssignal an A1 und einen Zweigstrom IP an A2.

Eine Konstantstromquelle QL legt einen Quellenstrom IL fest, der sich aufteilt in den Zweigstrom IP durch A2 und einen Reststrom IN. Der Reststrom IN steuert über T5 den durch T5, T6 gebildeten Stromspiegel und legt damit den Betriebsstrom IQ des Differenzverstärker fest. Vorzugsweise ist IN wesentlich kleiner als IQ, was beispielsweise durch das Flächenverhältnis der monolithisch integrierten Stromspiegeltransistoren T5, T6 als Proportionalitätsfaktor n einstellbar ist. Der Betriebsstrom IQ ist nicht notwendigerweise direkt proportional dem Reststrom IN. Für die Funktion der Schaltungsanordnung genügt eine monoton eindeutige Abhängigkeit, d.h. daß eine Änderung des Reststroms eine gleichlaufende Änderung des Betriebsstroms bewirkt. Beispielsweise kann zwischen den Emitter von T5 und GND ein Widerstand R eingefügt sein.

Für hohe Eingangssignale UE fließt der gesamte Betriebsstrom IQ als Ausgangsstrom IA durch den Ausgang A1 des Differenzverstärkers. Der Ausgangsstrom ist dann begrenzt auf IAmax = IQ (= n.IL), wodurch eine Begrenzung der Leistungsaufnahme und der Aussteuerung anderer Baugruppen durch den Ausgangsstrom IA erreicht werden kann.

Dagegen fließt bei entgegengesetzter Stromverteilung im Differenzverstärker insgesamt nur noch der Quellenstrom IL, der sich im Verhältnis n:1 auf IP bzw. IQ und auf IN aufteilt. Der Ausgangsstrom IA zeigt über den überwiegenden Bereich des Aussteuerungsbereichs des Differenzverstärkers eine exponentielle (dB-lineare) Abhängigkeit vom Eingangssignal UE und geht dann allmählich auf den Grenzwert n.IL über.

Der exponentielle Verlauf der Kennlinie kann bis zu einem Begrenzungswert IAmax verlängert werden, indem der Wert des Quellenstroms IL so gewählt wird, daß die dadurch bedingte Stromgrenze n.IL größer ist als der vorgesehene Begrenzungswert für den Ausgangsstrom IAmax und indem mit Erreichen dieses Begrenzungswerts eine Regelschleife einsetzt, die beispielsweise durch Begrenzung des Eingangssignals UE oder des Reststroms IN eine übergangslos einsetzende Begrenzung des Ausgangsstroms IA bewirkt. Als Ist-Wert für die Regelschleife wird vorzugsweise ein dem Ausgangsstrom proportionaler Sensorstrom herangezogen, der beispielsweise aus einem vom Ausgangsstrom gesteuerten Stromspiegel oder über einen basis- und emitterseitig mit dem Transistor T9 verbundenen weiteren Transistor wie in der Abbildung mit unterbrochener Linie als T8 angedeutet gewonnen wird.

Durch Transistoren parallel geschaltet zu T9, kann der Ausgangsstrom sowohl für verschiedene andere Schaltungsstufen aufgespalten werden, aber auch als Monitor-Ausgang verwendet werden.

Die erfindungsgemäße Schaltungsanordnung ist besonders vorteilhaft einsetzbar in einer Einrichtung zur Verstärkungsregelung AGC (Automatic Gain Control) insbesondere bei einer m-stufigen (m=1, 2,...) Verstärkeranordnung mit proportional zum Ausgangsstrom IA gesteuerter Verstärkung der einzelnen Verstärkungsstufen. Die Steuerung der Verstärkung erfolgt vorteilhafterweise über die stromproportionale Steilheit. Die ggf. mehreren Steuerströme können z.B. durch Aufteilung oder Spiegelung des Ausgangsstroms gewonnen werden. Besonders vorteilhaft ist eine derartige AGC-Einrichtung mit der erfindungsgemäßen Schaltungsanordnung zur Verstärkung amplitudenmodulierter, insbesondere amplitudenumgetasteter Signale wie z.B. die Funksignale von Zeitzeichensendern wie dem DCF 77, indem zur Demodulation der Signale das Eingangssignal des Differenzverstärkers herangezogen wird. Eine Pegelumtastung des unverstärkten Funksignals mit bestimmtem Pegeltastverhältnis führt dann unabhängig von dessen in einem weiten Dynamikbereich variierender Amplitude zu einem einheitlichen Signalhub des Eingangssignals des Differenzverstärkers.

Als einfache Baugruppen zur Abgabe eines begrenzten Ausgangsstroms nach Maßgabe eines Eingangssignals sind beispielsweise die Emitterschaltung eines Transistors oder die Differenzverstärkerschaltung eines Transistorpaars gebräuchlich. Bei der Differenzverstärkeranordnung ist eine Begrenzung des Ausgangsstroms durch die emitterseitige Stromquelle des Differenzverstärkers gegeben. Die Begrenzung des Ausgangsstroms setzt dabei aber nur allmählich ein, so daß sich vor Erreichen der Strombegrenzung eine Abweichung von dem dB-linearen (d.h. exponentiellen) Verlauf der Ausgangsstrom-Eingangssignal-Kennlinie ergibt, die beispielsweise bei Verwendung des Ausgangsstroms zur automatischen Verstärkungsregelung zu einem Verstärkungs- und Empfindlichkeitsverlust führen kann.

Die nachfolgend beschriebenen Anordnungen zur Begrenzung eines Ausgangsstroms ermöglichen eine definiert und ohne Ubergang einsetzende Begrenzung. Sie erlauben insbesondere die Gestaltung einer den Ausgangsstrom erzeugenden Schaltungsgruppe so, daß die Kennlinie bis zum Einsatz der Begrenzung einem gewünschten, insbesondere einem dB-linearen Verlauf wie die Schaltungsanordnung nach FIG. 1 folgt.

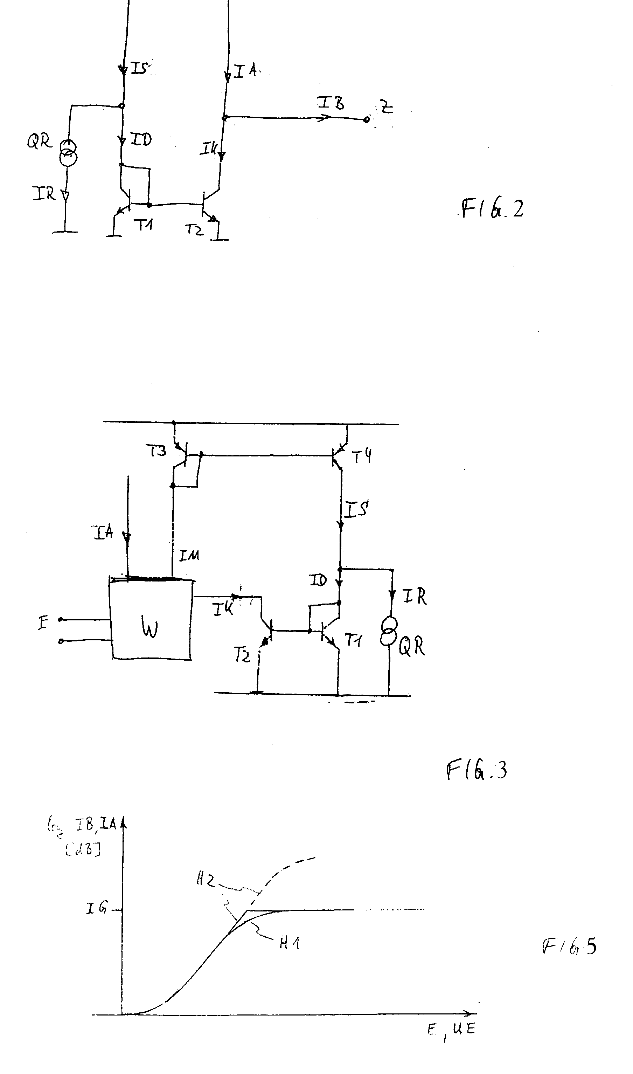

Bei der in FIG. 2 skizzierten Anordnung sind ein nicht notwendigerweise begrenzter Ausgangsstrom IA und ein diesem proportionaler Steuerstrom IS vorgesehen. Die Gewinnung des Steuerstroms IS ist in verschiedener Form aus dem Stand der Technik bekannt. Der Steuerstrom IS teilt sich auf zwei parallele Strompfade auf, wobei ein erster Strompfad mit einer Referenzstromquelle QR einen Referenzstrom IR abzieht und ein diesen Referenzstrom IR gegebenenfalls übersteigender Anteil des Steuerstroms IS als Differenzstrom ID in einem zweiten Strompfad den Transistor T1 als steuernden Teil des durch die Transistoren T1 und T2 gebildeten Stromspiegels durchfließt. Ein Strom ID durch T1 bewirkt einen dazu proportionalen gespiegelten Strom IK durch T2, der den nicht begrenzten Ausgangsstrom IA entsprechend verringert.

Für unter dem Wert des Referenzstroms IR liegende Werte des Steuerstroms IS fließt der gesamte Steuerstrom in den ersten Strompfad und es verbleibt kein Differenzstrom ID. Der Differenzstrom ID wird nicht negativ, was u.U. durch gleichrichtende Mittel wie den Transistor T1 sicherzustellen ist. Damit fließt auch kein Strom IK und der zum Ausgangsanschluß Z fließende Strom IB ist gleich dem Strom IA.

Für den Referenzstrom übersteigende Werte des Steuerstroms IS fließt ein Differenzstrom durch T1 und über den Stromspiegel wird ein Strom IK durch T2 von dem Ausgangsstrom IA abgezogen. Es ergibt sich auf einfache Weise, daß bei gleicher Proportionalität k zwischen IA und IS einerseits und IK und ID andererseits bei steigendem Strom IA ab IS=IR der Strom IB konstant bleibt und einen dem Referenzstrom IR mit demselben Faktor k proportionalen Wert einnimmt. Bei steuerbarer Stromquelle QR kann auch der Begrenzungswert IB auf einfache Weise gesteuert werden. Der Proportionalitätsfaktor des Stromspiegels kann beispielsweise durch das Flächenverhältnis der Transistoren T1 und T2 in einer monolithischen Anordnung eingestellt werden.

Bei der in FIG. 3 skizzierten Ausführungsform ist wiederum ein Steuerstrom IS vorgesehen, der sich in einen Referenzstrom und einen eventuell verbleibenden Differenzstrom aufteilt. Über den Stromspiegel T1, T2 wird ein Stellstrom IK erzeugt. Die Höhe des Steuerstroms IS ist über den Stromspiegel aus T3, T4 bestimmt durch einen Sensorstrom IM, der seinerseits proportional zu oder zumindest eindeutig abhängig von dem Ausgangsstrom IA einer Einrichtung W zur Erzeugung des Ausgangsstroms nach Maßgabe eines Eingangssignals E ist. Der Stellstrom IK wirkt in dieser Anordnung nicht unmittelbar reduzierend auf den Ausgangsstrom IA, sondern wirkt begrenzend auf eine in der Einrichtung W maßgebende Größe, wie beispielsweise Betriebsstrom, Verstärkung, Eingangssignal ein in der Weise, daß der Ausgangsstrom reduziert wird. Die Anordnung bildet damit eine Regelschleife, die bei Erreichen eines fest oder über die Stromquelle QR auch veränderlich vorgegebenen Begrenzungswerts des Ausgangsstroms IA bzw. des Sensorstroms IM einsetzt und den Ausgangsstrom IA bzw. IM begrenzt. Die Ströme innerhalb der Regelschleife können erheblich niedriger sein als der Ausgangsstrom IA.

FIG. 4 zeigt eine Einrichtung zur automatischen Verstärkungsregelung (AGC) unter Verwendung einer Anordnung nach FIG.2. Vorgesehen ist dabei eine insbesondere mehrstufige Verstärkeranordnung, deren Verstärkung mittels eines Stroms IA einstellbar ist. Die Verstärkerstufen können beispielsweise Differenzverstärker sein, deren Betriebsstrom durch IA bestimmt ist. Die Verstärkeranordnung sei beispielsweise zur variablen Verstärkung eines Funkempfangssignal e mit großem Amplitudendynamikbereich vorgesehen. Neben dem verstärkten Empfangssignal e' erzeugt die Verstärkeranordnung noch ein aus der Amplitude des verstärkten Signals abgeleitetes Stromsignal IE, welches zusammen mit einem Ladestrom Ic aus einer Stromquelle QC die Spannung UE an einem Kondensator CE bestimmt. Die Kondensatorspannung liegt an einem Eingang eines durch Transistoren T7, T9 in Differenzverstärkeranordnung gebildeten Spannungs-Strom-Wandlers, dessen anderer Eingang auf einem konstanten Referenzpotential UP, über das ggf. auch Temperaturabhängigkeiten der Differenzverstärkeranordnung kompensiert werden können liegt. Der Kollektorstrom von T9, der mit der Kondensatorspannung UE als Eingangssignal variert, bildet den Ausgangsstrom der Spannungs-Stromwandlerstufe und regelt die Verstärkung der Verstärkeranordnung V in der Weise, daß bei sinkender Amplitude des Empfangssignals e auch die Amplitude des verstärkten Signals e'sinkt und das Stromsignal IE geringer wird, was durch Anstieg der Kondensatorspannung UE zu einem höheren Ausgangsstrom IA und damit zu einer höheren Signalverstärkung in V führt bis sich ein neuer Gleichgewichtswert UE an CE einstellt. Die Anordnung der Stromquelle QL mit dem aus T5, T6 gebildeten Stromspiegel und der Aufteilung des Quellenstroms IL in die Teilströme IN und IP dient der Realisierung einer dB-linearen (exponentiellen) Abhängigkeit des Ausgangsstroms IB von der Eingangsspannung UE und reduziert zugleich die Stromaufnahme bei mittleren und kleinen Eingangsspannungen UE gegenüber einem bei schwachem Empfangssignal e und damit hoher Eingangsspannung UE benötigten hohen Ausgangsstrom IB. Der Ausgangsstrom IB soll aber auch bei sehr schwachem oder ganz fehlendem Empfangssignal nicht zu hohe Werte annehmen.

Eine Begrenzung des Ausgangsstroms ist bei hoher Eingangsspannung UE ohne zusätzliche Maßnahmen durch den über den Stromspiegel T5, T6 zu IN (= IL bei hohem UE) proportionalen Quellenstrom IQ an den verbundenen Emittern von T7, T9 gegeben. Diese Begrenzung setzt aber nur allmählich ein wie eingangs beschrieben und wie in FIG.4 durch den Kennlinienverlauf H1 angedeutet.

Durch Verwendung einer Anordnung zur Strombegrenzung wie z.B. in FIG. 2 oder FIG. 3 kann die Einrichtung zur Erzeugung des Ausgangsstroms so dimensioniert werden, daß die Kennlinie H2 bis zum vorgesehenen Grenzstromwert IG einem gewünschten, insbesondere einem dB-linearen Verlauf folgt. Der darüberhinausgehende Kennlinienverlauf ist wegen der einsetzenden Strombegrenzung ohne Belang.

Bei der in FIG. 4 skizzierten AGC-Einrichtung ist zur Strombegrenzung eine Anordnung nach FIG. 3 eingesetzt, wobei der Sensorstrom IM durch einen basis- und emitterseitig mit dem Transistor T9 verbundenen Transistor T8 als zum Ausgangsstrom IB proportionaler Strom bereitgestellt ist.

Die Wirkungsweise der Strombegrenzung ist weitgehend bereits zu FIG. 3 beschrieben. Der im Begrenzungsfall erzeugte Stellstrom IK kann beispielsweise auf den Betriebsstrom IQ reduzierend einwirken, indem der über den Stromspiegel T5, T6 zu IQ proportionale Strom IL bzw. IN durch Abzug des Stellstroms IK verringert wird (alternative Verbindung a in FIG.3).

Eine andere bevorzugte Möglichkeit der begrenzenden Einwirkung des Stellstroms ist in FIG. 4 durch die alternative Verbindung b skizziert. Hierbei wird die Kondensatorspannung UE als Eingangssignal der Spannungs-Stromwandlerstufe begrenzt. Bei dem beispielhaft gewählten Aufbau ist dann vorteilhaft, daß z.B. bei einem plötzlichen Einsetzen eines Empfangssignals der Kondensator CE nicht erst von einem hohen Wert entladen zu werden braucht.

## Patentansprüche

1. Schaltungsanordnung zur Erzeugung eines exponentiell von einem Eingangssignal (UE) abhängigen Ausgangssignals (IA) mit einem Differenzverstärker (T7, T9), der einen Eingang (E1, E2) für das Eingangssignal (UE), einen ersten Ausgang (A1) für das Ausgangssignal (IA) und einen zweiten Ausgang (A2) für ein Zweigsignal (IP) aufweist, dadurch gekennzeichnet, daß ein konstanter Quellenstrom (IL) vorgegeben ist, daß der zweigstrom (IP) durch den Quellenstrom (IL) auf einen Reststrom (IN) reduziert ist und daß der Betriebsstrom (IQ) des Differenzverstärkers (T7, T9) gleichlaufend zum Reststrom (IN) gesteuert ist.

2. Anordnung nach Anspruch 1, dadurch gekennzeichnet, daß ein Stromspiegel (T5, T6) den Betriebsstrom (IQ) proportional zu dem Reststrom (IN) erzeugt.

3. Anordnung nach Anspruch 1 oder 2, dadurch gekennzeichnet, daß eine Regelschleife vorgesehen ist, welche durch Einwirkung auf den Betriebsstrom (IQ) oder das Eingangssignal (UE) des Differenzverstärkers (T7, T9) das Ausgangssignal (IA) begrenzt.

4. Einrichtung zur Verstärkungsregelung mit einer Anordnung nach einem der Ansprüche 1 bis 3, dadurch gekennzeichnet, daß das Ausgangssignal (IA) ein Ausgangsstrom ist und eine m-stufige Verstärkeranordnung (V) in der Verstärkung jeder Verstärkerstufe proportional zu dem Ausgangsstrom (IA) gesteuert ist.

5. Einrichtung nach Anspruch 4, dadurch gekennzeichnet, daß die verstärkeranordnung (V) mit einem amplitudenmodulierten Empfangssignal (e) beaufschlagt ist und daß der Differenzverstärker (T7, T9) eingangsseitig mit einem Ausgang der Verstärkerstufe (V) verbunden ist, an welchem das Eingangssignal (UE) als demoduliertes Empfangssignal ansteht.

6. Anordnung nach Anspruch 3, dadurch gekennzeichnet, daß die Regelschleife zur Begrenzung des Ausgangssignals (IA) folgende Schaltungsteile enthält:
- eine Steuerstromquelle, die einen vom Ausgangssignals (IA) abhängigen Steuerstrom (IS) liefert,
- eine Referenzstromquelle (QR), welche den Steuerstrom (IS) um einen vorgegebenen Referenzstrom (IR) auf einen Differenzstrom (ID) reduziert,
- Mittel zur begrenzenden Rückwirkung auf das Ausgangssignal (IA) nach Maßgabe des Differenzstroms (ID).

7. Anordnung nach Anspruch 6, dadurch gekennzeichnet, daß die Mittel auf das Eingangssignal (UE) des Differenzverstärkers (T7, T9) begrenzend einwirken.

8. Anordnung nach Anspruch 6, dadurch gekennzeichnet, daß die Mittel auf den Betriebsstrom (IQ) des Differenzverstärkers (T7, T9) begrenzend einwirken.

9. Anordnung nach einem der Ansprüche 1 bis 8, dadurch gekennzeichnet, daß aus dem Differenzstrom (ID) über einen Stromspiegel (T1, T2) ein begrenzend einwirkender Stellstrom (IK) erzeugt wird.

10. Anordnung nach einem der Ansprüche 1 bis 6, dadurch gekennzeichnet, daß der Referenzstrom (IR) variabel vorgebbar ist.

## Claims

1. A circuit arrangement for generating an output signal (IA) which is exponentially dependent upon an input signal (UE), comprising a differential amplifier (T7, T9) having an input (E1, E2) for the input signal (UE), a first output (A1) for the output signal (IA) and a second output (A2) for a branch signal (IP), characterised in that a constant current source (IL) is provided, that the branch current (IP) is reduced to a residual current (IN) by the source current (IL), and that the operating current (IQ) of the differential amplifier (T7, T9) is controlled in the same direction as the residual current (IN).

2. An arrangement according to Claim 1, characterised in that a current mirror (T5, T6) generates the operating current (IQ) in proportion to the residual current (IN).

3. An arrangement according to Claim 1 or 2, characterised in that a control loop is provided which limits the output signal (IA) by influencing the operating current (IQ) or the input signal (UE) of the differential amplifier ((T7, T9).

4. A device for gain control comprising an arrangement according to one of Claims 1 to 3, characterised in that the output signal (IA) is an output current and a m-stage amplifier arrangement (V) is controlled in proportion to the output current (IA) in respect of the amplification of each amplifier stage.

5. A device according to Claim 4, characterised in that the amplifier arrangement (V) is supplied with an amplitude-modulated received signal (e) and that the differential amplifier (T7, T9) is connected at its input end to an output of the amplifier stage (V) at which the input signal (UE) occurs as demodulated received signal.

6. An arrangement according to Claim 3, characterised in that the control loop for limiting the output signal (IA) contains the following circuit components:
- a control current source which supplies a control current (IS) which is dependent upon the output signal (IA),
- a reference current source (QR) which reduces the control current (IS) by a predetermined reference current (IR) to a difference current (ID),
- means for exerting a limiting effect upon the output signal (IA) in accordance with the difference current (ID).

7. An arrangement according to Claim 6, characterised in that the means exert a limiting effect upon the input signal (UE) of the differential amplifier (T7, T9).

8. An arrangement according to Claim 6, characterised in that the means exert a limiting effect upon the operating current (IQ) of the differential amplifier (T7, T9).

9. An arrangement according to one of Claims 1 to 8, characterised in that a control current (IK) exerting a limiting effect is generated from the difference current (ID) by means of a current mirror (T1, T2).

10. An arrangement according to one of Claims 1 to 6, characterised in that the reference current (IR) can be preset in a variable manner.

## Revendications

1. Montage pour la production d'un signal de sortie (IA), qui dépend exponentiellement d'un signal d'entrée (UE), comportant un amplificateur différentiel (T7, T9), qui comporte une entrée (E1, E2) pour le signal d'entrée (UE), une première sortie (A1) pour le signal de sortie (IA) et une seconde sortie (A2) pour un signal de dérivation (IP), caractérisé en ce qu'un courant constant de source (IL) est prédéterminé, que le courant de dérivation (IP) est réduit par le courant de source (IL) à un courant résiduel (IL) et que le courant de fonctionnement (IQ) dans l'amplificateur différentiel (T7, 19) est commandé dans le même sens que le courant résiduel (IN).

2. Dispositif selon la revendication 1, caractérisé en ce qu'un miroir de courant (T5, T6) produit le courant de fonctionnement (IQ) proportionnellement au courant résiduel (IN).

3. Dispositif selon la revendication 1 ou 2, caractérisé en ce qu'il est prévu une boucle de régulation, qui limite le signal de sortie (IA) en agissant sur le courant de fonctionnement (IQ) ou sur le signal d'entrée (UE) de l'amplificateur différentiel (T7, T9).

4. Dispositif de régulation d'amplification comportant un dispositif selon l'une des revendications 1 à 3, caractérisé en ce que le signal de sortie (IA) est un courant de sortie et que l'amplification réalisée par un dispositif amplificateur (V) à m étages est commandée, au niveau de chaque étage amplificateur, proportionnellement au courant de sortie (IA).

5. Dispositif selon la revendication 4, caractérisé en ce que le dispositif amplificateur (V) est chargé par un signal de réception (e) modulé en amplitude, et que l'amplificateur différentiel (T7, T9) est relié côté entrée à une sortie de l'étage amplificateur (V), au niveau de laquelle le signal d'entrée (UE) est présent en tant que signal de réception démodulé.

6. Dispositif selon la revendication 3, caractérisé en ce que la boucle de régulation servant à limiter le signal de sortie (IA) contient les éléments de circuit suivants :
- une source de courant de commande, qui délivre un courant de commande (IS) qui dépend du signal de sortie (IA),
- une source de courant de référence (QR), qui réduit le courant de commande (IS), d'un courant de référence prédéterminé (IR), pour l'amener à un courant différentiel (ID),
- des moyens pour appliquer une réaction de limitation au signal de sortie (IA) en fonction du courant différentiel (ID).

7. Dispositif selon la revendication 6, caractérisé en ce que les moyens agissent de façon limitative sur le signal d'entrée (UE) de l'amplificateur différentiel (T7, T9).

8. Dispositif selon la revendication 6, caractérisé en ce que les moyens agissent d'une manière limitative sur le courant de fonctionnement (IQ) de l'amplificateur différentiel (T7, T9).

9. Dispositif selon l'une des revendications 1 à 8, caractérisé en ce qu'un courant de réglage (IK) à action limitative est produit à partir du courant différentiel (ID) par l'intermédiaire d'un miroir de courant (T1, T2).

10. Dispositif selon l'une des revendications 1 à 6, caractérisé en ce que le courant de référence (IA) peut être prédéterminé de manière à être variable.
